# EUROPÄISCHE PATENTSCHRIFT

(11) **EP 2 191 060 B1**
(45) Veröffentlichungstag und Bekanntmachung des Hinweises auf die Patenterteilung: **23.03.2011**
(21) Anmeldenummer: 08803776.7
(22) Anmeldetag: 05.09.2008
(51) Int. Cl.: D06N 3/00, H05K 1/18, H05B 3/34, H01B 5/14, A41D 13/005, B60N 2/56, D06M 11/84

(54) **ELEKTRISCH LEITFÄHIGES, FLEXIBLES FLÄCHENGEBILDE**
ELECTRICALLY CONDUCTIVE, FLEXIBLE WEB MATERIAL
STRUCTURE PLANE SOUPLE ÉLECTROCONDUCTRICE

(30) Priorität: 07.09.2007 DE 102007042644
(43) Veröffentlichungstag der Anmeldung: 02.06.2010
(73) Patentinhaber: Benecke-Kaliko AG, 30419 Hannover (DE)
(72) Erfinder: RITTER, Wolfgang, 67591 Offstein (DE)
(74) Vertreter: Finger, Karsten
(86) Internationale Anmeldenummer: PCT/EP2008/061807
(87) Internationale Veröffentlichungsnummer: WO 2009/034037

(56) Entgegenhaltungen:
- EP-A- 0 057 284
- WO-A-02/052899
- WO-A-2005/020246
- FR-A- 2 041 047
- GB-A- 1 069 592
- US-A- 5 824 996
- US-A1- 2001 002 669

## Beschreibung

Die vorliegende Erfindung betrifft elektrisch leitfähige, flexible Flächengebilde und deren Verwendung in flexiblen, flächigen Heizelementen (sog. Flächenheizelemente) sowie in Bekleidung.

Flexible elektrisch leitfähige Flächengebilde, beispielsweise elektrisch leitfähiges Textil und elektrisch leitfähige Folien, sind grundsätzlich für eine Reihe von Anwendungen von Interesse. Einen Schwerpunkt bildet die Verwendung elektrisch leitfähiger Textilien zur Abschirmung vor hochfrequenter elektromagnetischer Strahlung (Elektrosmog).

Verschiedentlich wurde die Verwendung elektrisch leitfähiger Textilien als Leiterbahnen oder als flexible Heizelemente vorgeschlagen (siehe z. B. DE 4233118 A1). Für diese Anwendungen haben sich elektrisch leitfähige Textilien jedoch bislang nicht durchgesetzt. Hierfür sind vermutlich zwei Hauptgründe zu nennen. Zum einen basiert die überwiegende Anzahl elektrisch leitfähiger Textilien auf Geweben oder Vliesen, die eine Vielzahl metallisierter Fäden oder Garne enthalten. Diese metallisierten Fäden bzw. Garne sind kostspielig und verleihen der Textilie eine unerwünschte Steifheit. Zum anderen ist eine ausreichende, elektrische Kontaktierung oftmals problematisch, so dass hohe Übergangswiderstände zwischen den Kontaktdrähten und dem elektrisch leitfähigen Textil auftreten. Dies kann im Extremfall dazu führen, dass es bei höheren elektrischen Leistungen, wie sie für den Betrieb von Heizelementen erforderlich sind, zu einer lokalen Überhitzung bis hin zu einer Verzunderung der Kontaktstelle kommen kann.

Die DE 4233118 schlägt zur Vermeidung hoher Übergangswiderstände zwischen einem elektrisch leitfähigen Gewebe und den Kontaktdrähten eine innige Verbindung der Kontaktdrähte und des Gewebes vor, so dass eine Vielzahl einzelner Kontaktstellen resultiert.

Die DE 202005010011 U1 schlägt vor, elektrisch leitfähige, beschichtete Flächengebilde im Anschlussbereich gezielt durch eine metallische Schicht zu verstärken, um dort eine stabile Lötverbindung herstellen zu können. Diese Vorgehensweise ist vergleichsweise aufwendig und für höhere Leistungen nicht zufriedenstellend.

Aus der EP 1284278 A2 und der W02005/020246 sind flexible, elektrisch leitfähige Flächengebilde bekannt, die eine polymergebundene, elektrisch leitfähige Beschichtung auf einem flexiblen, elektrischen Strom nicht leitenden flächigen Träger, z. B. einem Textil oder Leder, aufweisen. Zwar lassen sich derartige Flächengebilde sehr viel kostengünstiger herstellen als elektrisch leitfähige Textilien auf Basis metallisierter Fäden. Allerdings stellt sich bei diesen Materialien in besonderer Weise das Problem hoher Übergangswiderstände im Kontaktbereich zwischen den Zuleitungen und dem flexiblen, elektrisch leitfähigen Flächengebilde, da die bekannten Methoden zur Herstellung elektrischer Kontakte zwischen Kabeln und leitfähigen Textilien wie Crimpen oder Aufkleben zu sehr hohen Übergangswiderständen führt und andere Verfahren wie das in DE 4233118 vorgeschlagene Einarbeiten der Kontaktdrähte in das Gewebe oder ein Verlöten nicht möglich sind.

Die WO 02/052899 A1 offenbart eine Flächenheizung mit einer Heizschicht aus einem flexiblen, leitfähigen Kunststoff, die auf einen ebenfalls flexiblen Träger aus z.B. Gewebe, Vlies oder Faservlies aufgebracht ist. Dabei sind die Kontaktenden von Stromzuleitungsdrähten mit der Heizschicht vernäht oder verklebt, können aus Silber oder Kupferdrähten bestehen und vollständig mit dem elektrisch leitfähigen Kunststoff umgeben sein.

Die EP 0 057 284 A2 offenbart elektrische Leitkontakte aus metallisierten textilen Flächengebilden in Bandform, die mit Flächenheizungen durch Anheften, Ankleben oder Annähen verbunden werden können. Die Flächenheizungen, die in diesem Zusammenhang mit beschrieben werden, bestehen aus Metall, aus graphit- oder rußhaltigen Polymermischungen oder aus metallisierten textilen Flächengebilden.

Die FR 2.041.047 offenbart eine Wärmeeinrichtung (équipement chauffé), bei dem eine flexible Folie aus elektrisch leitendem Material mit zwei Elektroden verbunden ist. Die flexible Folie kann dabei eine Unterlage oder einen Träger Glasfasergewebe enthalten, der mit einer oberflächigen Lage aus leitfähigem Polymer versehen ist. Weitere Unterlagen und Deckschichten komplettieren die Wärmeeinrichtung. Die Elektroden werden aufgenäht, aufgeklebt oder durch andere Methoden mit der Folie verbunden.

Die GB 1,069,592 offenbart ein elektrisches Heizelement, bei dem ein mit einem elektrisch leitenden Material beschichtetes flexibles textiles Material in Taschen einer Decke/Heizdecke eingelegt wird. Das elektrisch leitende Beschichtungsmaterial kann ein Polymermaterial mit Rußpartikeln sein. Eine Deckschicht aus wärmeisolierendem Schaumkunststoff komplettiert die Wärmeeinrichtung und verhindert eine zu starke Wärmeübertragung. Die Elektroden werden so angenäht, dass ein sicherer Kontakt mit der leitfähigen Beschichtung besteht.

Die US 2001/0002669 A1 offenbart ein Wärmeelement aus leitfähigen fadenartigen "Kernen" verschiedener Art, die mit anderen nicht leitfähigen Materialien verbunden werden zur Bereitstellung von Heizstreifen, Heizflächen, Heizschläuchen etc. Diese Wärmeelemente werden mit flächigen und flexiblen Elektroden an eine Stromversorgung angeschlossen. Die fadenartigen Kerne können Polymerfäden sein, die eine Metallbeschichtung aufweisen und zu Wärmeelementen verwoben werden.

Die US 5,824,996 offenbart ein Wärmeelement aus leitfähigen und nicht-leitfähigen Fäden verschiedener Art, zur Bereitstellung von Heizstreifen, Heizflächen, Heizschläuchen etc.

Diese Wärmeelemente werden mit flächigen und flexiblen Elektroden an eine Stromversorgung angeschlossen.

Der vorliegenden Erfindung liegt daher die Aufgabe zu Grunde, ein elektrisch leitfähiges flexibles Flächengebilde auf Basis eines mit einer elektrisch leitfähigen Beschichtung versehenen flexiblen Trägers bereitzustellen, welches den Anschluss elektrischer Zuleitungen ohne hohe Übergangswiderstände ermöglicht.

Diese Aufgabe wird erfindungsgemäß dadurch gelöst, dass man ein elektrisch leitfähiges Flächengebilde, welches eine polymergebundene elektrisch leitfähige Beschichtung auf einem elektrisch nicht leitfähigen flächigen Träger aus flexiblem Material umfasst, mit wenigstens zwei Elektroden zum Einspeisen von elektrischem Strom versieht, wobei die Elektroden als Streifen aus einem elektrisch leitfähigen flexiblen Material ausgestaltet sind und wobei jede Elektrode mittels ein oder mehrerer Nähte auf dem flächigen Träger so fixiert ist, dass die jeweilige Kontaktfläche der Elektroden vollflächig mit der elektrisch leitfähigen Beschichtung in Kontakt befindlich ist, wobei die Elektroden und der flächige Träger in einer Weise relativ zueinander angeordnet sind, dass jede Elektrode mit ihrer Oberseite und ihrer Unterseite durch Umschlag des Flächengebildes so mit der elektrisch leitfähigen Beschichtung in Kontakt befindlich ist, dass letztere im Umschlagsbereich innenliegend ist.

Hierbei wird der Begriff "Streifen" im weiteren auch "Band" genannt oder mit dem Attribut "bandförmig" beschrieben.

Demnach betrifft die vorliegende Erfindung ein elektrisch leitfähiges, flexibles Flächengebilde, umfassend eine polymergebundene elektrisch leitfähige Beschichtung 2 auf einem flexiblen, elektrisch nicht leitfähigen flächigen Träger 1 und wenigstens zwei Elektroden 3 zum Einspeisen von elektrischem Strom, wobei die Elektroden 3 als flexibles Band aus einem elektrisch leitfähigen Material ausgestaltet sind und wobei jede Elektrode 3 mittels einer oder mehrerer Nähte 5 auf dem flächigen Träger 1 so fixiert ist, dass wenigstens eine Fläche der jeweiligen Elektrode 3 flächig mit der elektrisch leitfähigen Beschichtung 2 in Kontakt befindlich ist.

Bevorzugte Ausgestaltungen des elektrisch leitfähigen, flexiblen Flächengebildes sind in den Unteransprüchen 2 bis 9 sowie in der folgenden Beschreibung angegeben.
Figur 1 zeigt eine perspektivische Aufsicht einer bevorzugten Ausführungsform des erfindungsgemäßen elektrisch leitfähigen, flexiblen Flächengebildes mit Zuleitungen 4.
Figur 2 zeigt einen Schnitt durch eine Kante der in Figur 1 gezeigten, bevorzugten Ausführungsform eines erfindungsgemäßen elektrisch leitfähigen, flexiblen Flächengebildes.
Figur 3 zeigt eine Aufsicht auf einen Bereich der Kante der in Figur 1 gezeigten bevorzugten Ausführungsform eines erfindungsgemäßen, elektrisch leitfähigen, flexiblen Flächengebildes.

Die elektrisch leitfähigen, flexiblen Flächengebilde umfassen eine polymergebundene, elektrisch leitfähige Beschichtung 2 auf einem flexiblen, elektrisch nicht leitfähigen, flächigen Träger 1 und wenigstens zwei Elektroden 3 zum Einspeisen von elektrischem Strom.

Geeignete flexible, elektrischen Strom nicht leitende flächige Träger 1 sind beispielsweise textile Materialien wie Gewebe, Gestricke, Gewirke oder Vliese, weiterhin Leder, Kunststoff-Folien und Kunstleder. In einer bevorzugten Ausführungsform handelt es sich bei dem flächigen Träger um ein textiles Material, insbesondere um ein Gewebe. oder um Kunstleder.

Die textilen Materialen können aus Naturfasergarnen, Synthesefasergarnen und/oder Mischgarnen aufgebaut sein, wobei die Gewebe üblicherweise ein Flächengewicht im Bereich von 50 bis 400 g/m², vorzugsweise 80 bis 250 g/m² aufweisen. Als Fasermaterialien kommen grundsätzlich alle für die Herstellung von Textilien üblicherweise eingesetzten Fasermaterialien in Betracht. Hierzu zählen Baumwolle, Wolle, Hanffaser, Sisalfasern, Flachs, Ramie, Polyacrylnitrilfasern, Polyesterfasern, Polyamidfasern, Viskosefasern, Seide, Acetatfasern, Triacetatfasern, Aramidfasern und dergleichen sowie Mischungen dieser Fasermaterialien. Geeignet sind auch Glasfasern sowie Mischungen der vorgenannten Fasermaterialien mit Glasfasern z. B. Glasfaser/Kevlar-Mischungen. Vorzugsweise verwendet man ein Trägermaterial, das temperaturbeständig ist, z. B. bis Temperaturen von 200 °C oder darüber. Beispiele für temperaturbeständige Trägermaterialien sind Textilien auf Basis von Glasfasern und/oder Aramidfasern oder auf Basis von Mischungen von Glasfasern und/oder Aramidfasern mit konventionellen Fasern wie Baumwolle, Flachs, Sisal, Hanf, die überwiegend, d.h. zu wenigstens 50 %, aus Aramid- und/oder Glasfasern bestehen, sowie Leder oder Kunstleder.

Der konventionelle, den elektrischen Strom nicht leitfähige flächige Träger 1 weist eine polymergebundene, elektrisch leitfähige Beschichtung 2 auf. Derartige elektrisch leitfähige, flexible Beschichtungen sowie flexible Flächengebilde, welche eine solche Beschichtung auf einem flexiblen, elektrisch nicht leitfähigen flächigen Träger aufweisen, sind beispielsweise aus der EP 1284278, der US 5,786,785 und der WO2005/0200246 bekannt, auf deren Offenbarung hiermit vollumfänglich Bezug genommen wird. Bei diesen elektrisch leitfähigen Beschichtungen handelt es sich um polymergebundene Beschichtungen, die im Wesentlichen aus einem oder mehreren Bindemittel-Polymeren und einem feinteiligen Pulver, welches den elektrischen Strom leitet, aufgebaut sind.

Als elektrisch leitfähige Pulver (Pulver P) kommen grundsätzlich alle die für diesen Zweck bekannten elektrisch leitfähigen Pulvermaterialien in Betracht, z. B. Metallpulver wie Kupferpulver oder Zinkpulver, Rußpulver, elektrisch leitfähige Polymere, z. B. Polythiophene, Polypyrrole, Polyacetylene und dergleichen, sowie Kohlefasern, wie sie üblicherweise zur Antistatikausrüstung von Oberflächen eingesetzt werden. Vorzugsweise handelt es sich bei dem Pulvermaterial um ein feinteiliges Material, dessen Partikel eine Kern-Schale-Morphologie aufweisen, wobei die Schale von einem Material, welches den elektrischen Strom leitet, gebildet wird, und der Kern aus einem Isolatormaterial besteht. Bevorzugt sind elektrisch leitfähige Pulver mit Kern-Schale-Morphologie, deren Pulverteilchen eine Edelmetallbeschichtung, beispielsweise eine Silberbeschichtung, auf einem Isolatormaterial aufweisen.

Als Edelmetalle für die Edelmetallbeschichtung kommen grundsätzlich Gold und Silber und deren Legierungen sowie deren Legierungen mit legierbaren Metallen in Betracht. Der Edelmetallanteil in den Legierungen beträgt üblicherweise wenigstens 50 Gew.-%, vorzugsweise wenigstens 70 Gew.-%. Als Edelmetallbeschichtung hat sich insbesondere Silber oder eine silberhaltige Legierung bewährt, deren Silberanteil vorzugsweise wenigstens 50 Gew.-% und insbesondere wenigstens 70 Gew.-%, bezogen auf die Legierung, beträgt. Als legierbare Metalle kommen Kupfer, Gold, Platinmetalle, Zink, Nickel oder andere mit Gold bzw. Silber Legierungen bildende Metalle in Betracht.

Als Isolatormaterial für den Kern kommen insbesondere oxidische Materialien, z. B. keramische Materialien, Kunststoffe oder insbesondere Glas in Betracht. Als Gläser sind übliche Alkali- und Erdalkalisilikat-Gläser sowie Borosilikat-Gläser, Aluminosilikat-Gläser, Borat-Gläser, Germanat-Gläser, Phosphat-Gläser und dergleichen geeignet. Der Kern kann massiv sein oder ist vorzugsweise als Hohlkörperkugel ausgestaltet. Als elektrisch leitfähige Pulver sind grundsätzlich auch Metallpulver mit einer Edelmetallbeschichtung geeignet, d. h. der Kern derartiger Pulver ist ein Nicht-Edelmetall, wie beispielsweise Kupfer, Zink, Nickel, Eisen, Zinn und dergleichen, oder eine Legierung, die überwiegend aus diesen Nicht-Edelmetallen besteht.

Vorzugsweise weist der Kern, und damit auch die Pulverteilchen, eine regelmäßige Gestalt, z. B. eine kugelförmige oder ellipsoide Gestalt, auf, wobei das Verhältnis von größtem zu kleinstem Durchmesser einen Wert von 5:1, insbesondere 2:1 nicht überschreitet.

Die Pulverteilchen P weisen in der Regel einen mittleren Durchmesser von 1 bis 150 µm, häufig 1 bis 100 µm, vorzugsweise 2 bis 70 µm, insbesondere 5 bis 50 µm, besonders bevorzugt 10 bis 40 µm und ganz besonders bevorzugt 10 bis 30 µm auf. In einer speziellen Ausführungsform liegt er im Bereich von 10 bis 20 µm. Vorzugsweise weisen die Teilchen einen D₁₀-Wert nicht unterhalb 2 µm und insbesondere im Bereich von 4 µm bis 25 µm auf. Der D₉₀-Wert der Pulverteilchen wird vorzugsweise einen Wert von 100 µm und insbesondere von 70 µm nicht überschreiten und liegt besonders bevorzugt im Bereich von 15 µm bis 60 µm. Unter dem D₁₀-Wert bzw. dem D₉₀-Wert versteht der Fachmann den Teilchendurchmesser, den 10 bzw. 90 Gew.-% der Pulverteilchen unterschreiten. Dementsprechend bezieht sich hier der mittlere Teilchendurchmesser auf das Gewichtsmittel, und entspricht folglich dem Durchmesser, den 50 Gew.-% der Teilchen über- bzw. unterschreiten.

Der Gewichtsanteil an Edelmetall bzw. Edelmetall-Legierung in dem Pulver P beträgt in der Regel wenigstens 3 Gew.-% und vorzugsweise wenigstens 5 Gew.-% und wird in der Regel einen Wert von 70 Gew.-% und vorzugsweise 50 Gew.-%, jeweils bezogen auf das Gesamtgewicht des Pulvers, nicht überschreiten. Insbesondere liegt er im Bereich von 10 bis 40 Gew.-% und besonders bevorzugt im Bereich von 15 bis 35 Gew.-%.

Die in den elektrisch leitfähigen Beschichtungen verwendeten Pulver P sind bekannt und im Handel erhältlich. Geeignete elektrisch leitfähige Pulver P mit einem Kern aus elektrisch nicht leitfähigen Material werden beispielsweise unter dem Handelsbezeichnung Conduct-O-Fil® Silver Coated Hollow Glass Spheres (Glashohlkugel, Borosilikatglas, 20 bis 33 ± 2 % Silber), z. B. die Typen SH230S33, SH400S33, SH400S33; Conduct-O-Fil® Silver Coated Glass Spheres (Glasvollkugel, 4 bis 20± 2 % Silber), z. B. die Typen S-2429-S, S-3000-S, S-3000-S2E, S-3000-S2M, S-3000-S3E, S-3000-S3M, S-3000-S3N, S-3000-S4M, S-4000-S3, S-5000-S2, S-5000-S3, S-2429-S, S-2429-S, S-2429-S, und Conduct-O-Fil® Silver Coated Hollow Ceramic Additive (Keramikhohlkugel, 16 bis 30 ± 2 % Silber), z. B. die Typen AG-SL 150-16-TRD und AG-SL 150-30-TRD, von der Firma Potters Industries Inc. Valley Forge, PA USA bzw. von der Firma Potters-Ballotini, Kirchheim-Bolanden/Deutschland, vertrieben.

Bei dem versilberten Metallpulver handelt es sich insbesondere um versilbertes Kupferpulver, z. B. um versilberte Kupferblättchen, vorzugsweise mit einer Größe im Bereich von 1 bis 100 µm. Der Silberanteil beträgt in der Regel 1 bis 50 Gew.-%, z. B. 5 bis 25 Gew.-%, bezogen auf das Metallpulver. Versilberte Metallpulver, insbesondere versilbertes Cu-Pulver, z. B. in Form versilberter Metallblättchen, sind bekannt und werden z. B. unter der Bezeichnung KONTAKTARGAN® von der Fa. Eckart, Fürth/Deutschland, vertrieben.

In einer ersten Ausführungsform umfasst das elektrisch leitfähige Pulver ausschließlich (d. h. zu mindestens 99 %, bezogen auf das Gesamtgewicht des Pulvers) wenigstens ein Pulver mit einem Kern aus elektrisch nicht leitfähigem Material. In einer ganz bevorzugten Ausführungsform werden als Pulver mit Silber beschichte Glashohlkugeln mit einem Silbergehalt im Bereich von 15 bis 35 Gew.-% und einem mittleren Teilchendurchmesser im Bereich von 10 bis 20 µm eingesetzt. In einer weiteren bevorzugten Ausführungsform werden als Pulver mit Silber beschichte Glasvollkugeln mit einem Silbergehalt im Bereich von 4 bis 20 Gew.-% und einem mittleren Teilchendurchmesser im Bereich von 10 bis 40 µm eingesetzt.

In einer anderen bevorzugten Ausführungsform wird als elektrisch leitfähiges Pulver eine Mischung eines Pulvers mit einem Kern aus elektrisch nicht leitendem Material, z. B. mit Silber beschichtete Glashohlkugeln, und ein Metallpulver mit Edelmetallbeschichtung, z. B. das hier beschriebene versilberte Kupferpulver, eingesetzt. Das Gewichtsverhältnis von Metallpulver mit Edelmetallbeschichtung zu dem Pulver mit elektrisch nicht leitfähigem Kernmaterial liegt dann vorzugsweise im Bereich von 5:1 bis 1:5 und insbesondere im Bereich von 5:2 bis 1:5.

Die Verwendung von anderen feinteiligen, elektrisch leitfähigen Materialien EM, z. B. Metallpulver, wie Kupferpulver oder Zinkpulver, Rußpulver, elektrisch leitfähige Polymere, z. B. Polythiophene, Polypyrrole und dergleichen oder Polythiophen/Polystyrolsulfonat-Mischungen, oder Kohlefasern, wie sie üblicherweise zur AntistatikAusrüstung von Oberflächen eingesetzt werden, ist ebenfalls möglich. Der Anteil an derartigen Materialien in der elektrisch leitfähigen Beschichtung wird vorzugsweise 30 Gew.-%, und insbesondere 20 Gew.-%, bezogen auf das elektrisch leitfähige Pulver nicht überschreiten. Bevorzugt ist die Mitverwendung, z. B. in einer Menge von 0,5 bis 20 Gew.-%, bezogen auf das elektrisch leitfähige Pulver, von elektrisch leitfähigen Polymeren, z. B. Polythiophene, Polypyrrole und dergleichen oder Polythiophen/Polystyrolsulfonat-Mischungen. Beispiele für derartige Polymere sind insbesondere Poly(3,4-(ethylendioxy)thiophen)/Polystyrolsulfonat, das unter der Handelsbezeichnung Baytron® P von der Fa. Bayer AG, Leverkusen/Deutschland, vertrieben wird.

Weiterer Bestandteil der elektrisch leitfähigen Beschichtung ist ein polymeres Bindemittel (Bindemittel B). Hierbei handelt es sich in der Regel um ein filmbildendes Polymer, das gegebenenfalls bei erhöhter Temperatur einen zusammenhängenden Film auf einer Oberfläche zu bilden vermag. Das Polymer hat die Rolle eines Bindemittels und führt zu einer Haftung des elektrisch leitfähigen Pulvers auf der Oberfläche des Trägermaterials.

Das Gewichtsverhältnis von polymerem Bindemittel B zu Pulver P liegt dabei vorzugsweise im Bereich von 1:1,1 bis 1:20, insbesondere im Bereich von 1:1,2 bis 1:15, besonders bevorzugt im Bereich 1:1,4 bis 1:8 und ganz besonders bevorzugt 1:1,5 bis 1:5.

Es ist bevorzugt, wenn das Polymer eine Glasübergangstemperatur T_{G} im Bereich von -40 bis 100 °C, vorzugsweise im Bereich von -20 bis +60 °C, insbesondere im Bereich von -10 bis +40 °C, aufweist. Sofern das polymere Bindemittel mehrere Polymerkomponenten umfasst, sollte zumindest der Hauptbestandteil eine Glasübergangstemperatur in diesem Bereich aufweisen. Insbesondere liegt die Glasübergangstemperatur des Hauptbestandteils im Bereich von -20 °C bis +60 °C und besonders bevorzugt im Bereich von -10 °C bis +40 °C. Vorzugsweise weisen alle polymeren Bindemittelkomponenten eine Glasübergangstemperatur in diesen Bereichen auf. Bei zu niedriger Glasübergangstemperatur besteht die Gefahr, dass die Oberfläche klebrig ist. Die angegebenen Glasübergangstemperaturen beziehen sich dabei auf die gemäß ASTM-D 3418-82 mittels DSC bestimmte "midpoint temperature". Im Falle vernetzbarer Bindemittel bezieht sich die Glasübergangstemperatur auf den unvernetzten Zustand.

Beispiele für als Bindemittel geeignete filmbildende Polymere basieren auf den folgenden Polymerklassen:
(1) Polyurethan-Harze;
(2) Acrylatharze (Reinacrylate: Copolymere aus Alkylacrylaten und Alkylmethacrylaten);
(3) Styrolacrylate (Copolymere aus Styrol und Alkylacrylaten);
(4) Styrol/Butadien-Copolymerisate;
(5) Polyvinylester, insbesondere Polyvinylacetate und Copolymere des Vinylacetats mit Vinylpropionat;
(6) Vinylester-Olefin-Copolymere, z. B. Vinylacetat/Ethylen-Copolymere;
(7) Vinylester-Acrylat-Copolymere, z. B. Vinylacetat/Alkylacrylat-Copolymere sowie Vinylacetat/Alkylacrylat/Ethylen-Terpolymere;
(8) Silikonkautschuke (Polysiloxane).

Derartige Polymere sind bekannt und im Handel erhältlich, z. B. Polymere der Klassen (2) bis (7) in Form wässriger Dispersionen unter den Bezeichnungen ACRONAL, STY-ROFAN, BUTOFAN (BASF-AG), MOWILITH, MOWIPLUS, APPRETAN (Clariant), VINNAPAS, VINNOL (WACKER). Wässrige, für das erfindungsgemäße Verfahren geeignete Polyurethan-Dispersionen (1) sind insbesondere solche, die für die Beschichtung von Textilien verwendet werden (siehe z. B. J. Hemmrich, Int. Text. Bull. 39, 1993, Nr. 2, S. 53-56; "Wässrige Polyurethan-Beschichtungssysteme" Chemiefasern/Textilind. 39 91 (1989) T149, T150; W. Schröer, Textilveredelung 22, 1987, S. 459-467). Wässrige Polyurethandispersionen sind im Handel erhältlich, z. B. unter den Handelsbezeichnungen Alberdingk® der Fa. Alberdingk, Impranil® der Fa. BAYER AG, Permutex® der Fa. Stahl, Waalwijk, Niederlande, der Fa. BASF Aktiengesellschaft oder können nach bekannten Verfahren hergestellt werden, wie sie beispielsweise in "Herstellverfahren für Polyurethane" in Houben-Weyl, "Methoden der organischen Chemie", Band E 20/Makromolekulare Stoffe, S. 1587, D. Dietrich et al., Angew. Chem. 82 (1970), S. 53 ff., Angew. Makrom. Chem. 76, 1972, 85 ff. und Angew. Makrom. Chem. 98, 1981, 133-165, Progress in Organic Coatings, 9, 1981, S. 281-240, bzw. Römpp Chemielexikon, 9. Auflage, Band 5, S. 3575 beschrieben werden.

Die Bindemittel können selbstvernetzend sein, d. h. die Polymere weisen funktionelle Gruppen (vernetzbare Gruppen) auf, die beim Trocknen der Zusammensetzung, gegebenenfalls beim Erwärmen, miteinander oder mit einem niedermolekularen Vernetzer unter Bindungsbildung reagieren.

Neben dem Polymer und dem elektrisch leitfähigen Pulver können die elektrisch leitfähigen Beschichtungen noch bis zu 20 Gew.-%, in der Regel jedoch nicht mehr als 10 Gew.-% weitere Hilfsmittel enthalten. Hierzu zählen UV-Stabilisatoren, Dispergierhilfsmittel, oberflächenaktive Substanzen, Verdicker, Entschäumer, schaumbildende Mittel, Schaumstabilisatoren, Mittel zur Einstellung des pH-Wertes, Antioxidantien, Katalysatoren für eine etwaige Nachvernetzung, Hydrophobiermittel sowie Konservierungsmittel und Farbmittel. In der Regel machen das Polymer und das Pulver insgesamt wenigstens 80 Gew.-% und häufig wenig 90 Gew.-%, bezogen auf das Gesamtgewicht der elektrisch leitfähigen Beschichtung aus.

Die Herstellung einer elektrisch leitfähigen Beschichtung auf einem den elektrischen Strom nicht leitenden flexiblen Träger bzw. Trägermaterial 1 kann in Analogie zu bekannten Verfahren zum Aufbringen von Beschichtungen auf flexible flächige Träger erfolgen, z.B. durch Drucken, Rakeln, Pflatschen, Streichen und dergleichen, wie beispielsweise in EP 1284278 oder WO 2005/020246 beschrieben. Derartige Verfahren sind dem Fachmann der Textiltechnik geläufig.

Die elektrisch leitfähige Beschichtung kann vollflächig, wie in EP 1284278 beschrieben, oder teilflächig sein, wie in WO 2005/020246 beschrieben. Vollflächig bedeutet, dass die Beschichtung in dem beschichteten Bereich des flächigen Trägers eine gleichmäβige Stärke aufweist. Eine teilflächige Beschichtung bedeutet, dass die Beschichtung ein Muster einer Vielzahl zusammenhängender beschichteter Bereiche bildet, und eine Vielzahl nicht zusammenhängender unbeschichteter Bereiche aufweist. Beispiele hierfür sind netzförmige Muster wie in WO 2005/020246 beschrieben. Bei den teilflächigen Beschichtungen machen die beschichteten Bereiche in der Regel 10 bis 70 % und insbesondere 20 bis 60 % der Gesamtfläche der teilflächigen Beschichtung, d. h. der beschichteten und unbeschichteten Bereiche, aus.

Die Beschichtung weist in der Regel eine Stärke von wenigstens 5 µm in den beschichteten Bereichen auf. Insbesondere liegt die Beschichtungsstärke in den beschichteten Bereichen im Bereich von 10 µm bis 200 µm. Die Auflage an polymergebundener Beschichtung beträgt in der Regel 5 bis 200 g/m², häufig 10 bis 150 g/m², wobei in den Bereichen eines teilflächigen Auftrags die Auflage typischerweise im Bereich von 5 bis 100 g/m² und insbesondere im Bereich von 10 bis 80 g/m² liegt, wobei bei einer vollflächigen Beschichtung die Auflage typischerweise im Bereich von 10 bis 200 g/m² und insbesondere im Bereich von 20 bis 150 g/m² liegt.

In einer bevorzugten Ausführungsform der Erfindung weist das elektrisch leitfähige Flächengebilde zumindest in einem Teilbereich einen teilflächigen Auftrag auf. Im Bereich der Elektroden 3 ist die elektrisch leitfähige Beschichtung 2 vorzugsweise vollflächig, kann aber auch teilflächig sein. Die elektrisch leitfähige Beschichtung 2 kann auch in Form einer oder mehrerer diskreter Leiterbahnen ausgestaltet sein, wobei jede Leiterbahn an ihrem Anfangs- und Endpunkt oder ein Bündel mehrerer Leitbahnen an ihren Anfangs- und Endpunkten jeweils eine Elektrode 3 mit bandförmiger Ausgestaltung aufweisen.

Erfindungsgemäß sind die Elektroden 3 als ein flexibles Band aus einem elektrisch leitfähigen Material ausgestaltet. Der Begriff "Band" bzw. "bandförmig" bedeutet, dass die Dicke bzw. Stärke der Elektrode deutlich geringer ist als ihre Breite, wobei das Verhältnis von Breite zu Dicke in der Regel wenigstens 5 : 1 und häufig wenigstens 10:1 beträgt. In der Regel wird jedoch das Verhältnis Breite : Dicke einen Wert von 100 : 1 und insbesondere 50 : 1 nicht überschreiten. Die Breite der Elektrode 3 liegt typischerweise im Bereich von 3 mm bis 2 cm und häufig im Bereich von 5 mm bis 1,5 cm. Die Dicke der bandförmig ausgestalteten Elektrode 3 liegt typischerweise im Bereich von 0,1 mm bis 3 mm und häufig im Bereich von 0,2 mm bis 2 mm. Die Länge der Elektrode hängt naturgemäß von dem Flächenbereich ab, durch den ein Stromfluss gewünscht wird, sowie von dem beabsichtigten Leistungseintrag an elektrischer Energie. Sie kann wenige Zentimeter bis hin zu mehreren Metern betragen, z. B. 1 cm bis 200 cm, häufig 10 cm bis 100 cm. Typischerweise werden die Länge und die Breite der Elektrode so gewählt, dass eine Kontaktfläche von wenigstens 0,1 cm², vorzugsweise wenigstens 0,2 cm² und insbesondere wenigstens 0,3 cm² pro Watt elektrischer Energie resultiert. Die Obergrenze der Kontaktfläche unterliegt naturgemäß keiner oder nur kostenbedingten Beschränkungen und beträgt häufig nicht mehr als 20 cm²/Watt und insbesondere nicht mehr als 10 cm²/Watt.

Die Größe derartiger Flächengebilde hängt naturgemäß von der gewünschten Anwendung ab. In der Regel wird ein Elektrodenabstand von 1,5 m jedoch nicht überschritten. Häufig liegt der Abstand zwischen zwei benachbarten Elektroden im Bereich von 10 cm bis 1,5 m und insbesondere im Bereich von 20 cm bis 1 m. Als Elektrodenabstand gilt die Entfernung der Flächenschwerpunkte der Elektroden.

Als Elektrodenmaterial kommen grundsätzlich alle metallischen bandförmigen Gebilde in Betracht, die flexibel oder starr sein können und vorzugsweise flexibel sind. Zu nennen sind beispielsweise metallische oder metallisierte Folien, die beidseitig eine Metalloberfläche aufweisen, sowie sogenannte Schmalbänder, d. h. Gewebe- oder Gewirke aus metallischen oder metallisierten Fäden. Als Metalle für die Elektrodenmaterialien kommen insbesondere Kupfer, Aluminium und Zinn sowie Edelmetalle, z. B. Silber, Gold und/oder Platin und deren Legierungen in Betracht. Bei den Folienmaterialien kann es sich um Metallfolien, z.B. Kupfer- oder Zinnfolien bzw. Bänder aus diesen Folienmaterialien, oder um metallisierte Folien handeln. Unter metallisierten Folien versteht man Folien, die eine Metallbeschichtung auf einem inerten Träger, beispielsweise Polyester und/oder Polyamid, aufweisen. In einer bevorzugten Ausführungsform der Erfindung wird als Elektrodenmaterial ein Band aus einem Kupfer-, Zinn oder Aluminiumfolienmaterial eingesetzt, wobei die Metallfolie verzinnt, versilbert oder vergoldet sein kann. Die Metallfolien können auch selbstklebend sein.

Erfindungsgemäß ist jede Elektrode 3 mittels ein oder mehrerer Nähte 5 auf dem flächigen Träger 1 so fixiert, dass wenigstens eine Fläche der jeweiligen Elektrode 3 flächig mit der elektrisch leitfähigen Beschichtung 2 in Kontakt befindlich ist. Als Nähte kommen vorzugsweise solche Nähte in Betracht, die zu einem Anpressen der Elektrode an die elektrisch leitfähige Beschichtung führen. Zu nennen sind Nähte, die mittels Blindstich, Kreuzstich, Zick-Zack-Strich, Rautenstich oder dergleichen ausgeführt sind. Denkbar sind auch Kombinationen zweier oder mehrerer Nähte, die im gleichen Stich oder mit unterschiedlichen Stichen ausgeführt sein können. Vorzugsweise penetriert wenigstens eine Naht das Elektrodenmaterial. Die vorgenannten Nähte können auch als Doppelfadenstich ausgeführt sein.

Vorzugsweise wird die Naht von einem elastischen Fadenmaterial gebildet. Als Fadenmaterialien kommen insbesondere elastische Fadenmaterialien, Kunststoffmaterialien wie PUE-Fäden, d.h. Fäden mit Polyester- und Polyurethanbestandteilen (= Elastan-Fäden), z.B. die unter den Handelbezeichnungen Dorlastan, Lycra und Spandex vertriebenen Fadenmaterialien, in Betracht. Eine Übersicht über derartige Fasermaterialien findet sich beispielsweise in M. Peter, Grundlagen der Textilveredlung, 12. Auflage, Deutscher Fachverlag, S. 252f. Geeignet sind auch Metallfäden oder metallisierte Fäden.

Neben der Fixierung durch ein oder mehrere Nähte können auch andere Mittel zur Unterstützung der Fixierung eingesetzt werden, z. B. Klebstoffe, beispielsweise elektrisch leitfähige Klebstoffe, aber auch konventionelle Klebstoffe.

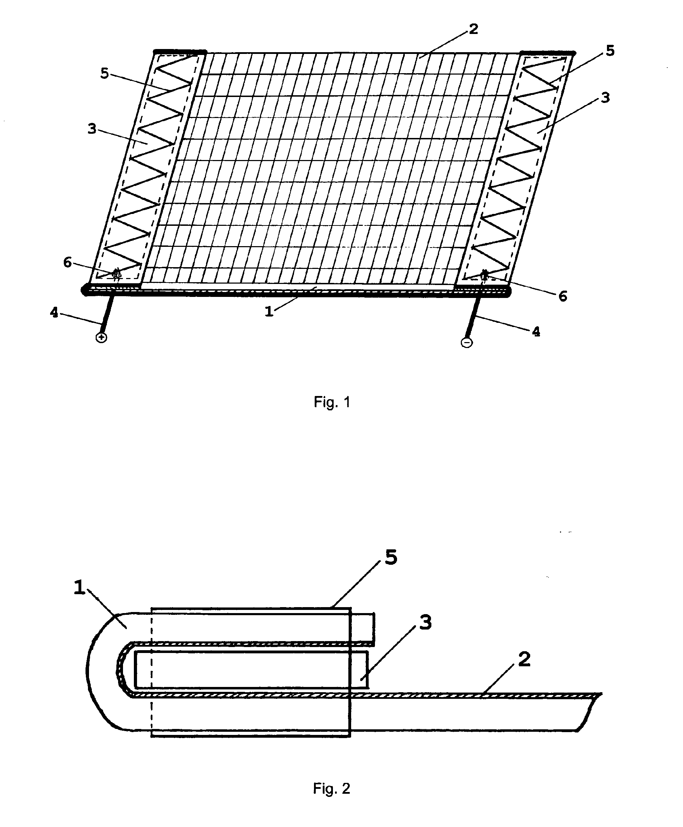

In einer ersten Ausführungsform der Erfindung erfolgt die Fixierung der Elektroden 3 auf dem flächigen Träger 1 in einer Weise, dass nur eine Fläche der jeweiligen Elektrode 3 flächig mit der elektrisch leitfähigen Beschichtung 2 in Kontakt befindlich ist. In einer bevorzugten Ausführungsform sind wenigstens eine und insbesondere beide Elektroden 3 und der flächige Träger 1 in einer Weise relativ zueinander angeordnet, dass wenigstens eine Elektrode 3 und vorzugsweise zwei Elektroden 3 jeweils mit ihrer Oberseite und ihrer Unterseite (d. h. die flächigen Seiten) mit der elektrisch leitfähigen Beschichtung 2 in Kontakt befindlich sind. Dies lässt sich beispielsweise dadurch erreichen, dass man den flächigen Träger in denjenigen Bereichen, in denen ein Kontakt mit der Elektrode erzielt werden soll, umschlägt, so dass die elektrisch leitfähige Beschichtung im Umschlagsbereich innenliegend ist, und die bandförmige Elektrode in diesem Umschlagsbereich mit einen oder mehreren Nähten fixiert. Auf diese Weise erreicht man, dass die Elektrode mit ihrer Oberseite und ihrer Unterseite mit der elektrisch leitfähigen Beschichtung 2 in Kontakt befindlich ist. In bevorzugten Ausführungsformen der Erfindung, wie sie in Figur 1 gezeigt wird, sind die Ränder des elektrisch leitfähigen Flächengebildes in Richtung der elektrisch leitfähigen Beschichtung umgeschlagen und die Elektroden 3 sind jeweils innenliegend in den umgeschlagenen Bereichen angeordnet. Durch ein oder mehrere Nähte werden die jeweilige Elektrode 3 und der jeweilige Umschlag, wie oben beschrieben, fixiert.

Die Elektroden 3 erlauben den Anschluss beliebiger elektrischer Leiter 4, insbesondere den Anschluss an Metallkabel, z.B. Litzenkabel. Die Verbindung des elektrischen Leiters 4 mit der Elektrode 3 kann in üblicher Weise erfolgen, z.B. im Falle metallischer Leiter durch Verlöten oder Verkleben mit einem elektrisch leitfähigen Kleber oder durch Crimpen.

In den Figuren 1 bis 3 werden folgende Bezugszeichen verwendet:
1 (flächiger) Träger
2 (elektrisch leitfähige) Beschichtung
3 Elektrode
4 Zuleitung
5 Naht
6 stoffschlüssige Verbindungsstelle.

Figur 1 zeigt eine solche Anordnung mit zwei Elektroden 3, die an gegenüberliegenden Rändern des flächigen Trägers 1 angeordnet sind, wobei diese gegenüberliegenden Ränder jeweils so umgeschlagen sind, dass die elektrisch leitfähige Beschichtung 2 im Umschlagsbereich innenliegend ist, wobei die jeweiligen Elektroden 3 ebenfalls im Umschlag angeordnet sind, so dass ihre Oberseite und ihre Unterseite mit der elektrisch leitfähigen Beschichtung 2 in Kontakt befindlich sind. Die beiden Umschläge und damit auch die Elektrode werden gemäß der Ausführungsform in Figur 1 jeweils durch Zick-Zack-Nähte 5 fixiert, wobei auch andere Nähte ebenfalls zur Fixierung geeignet sind. Zusätzlich werden in Figur 1 Zuleitungen 4 für den elektrischen Strom gezeigt, die an den jeweiligen Elektroden fixiert sind, beispielsweise durch eine Löt- oder Klebestelle (6), z.B. durch Verlöten oder Verkleben mit einem elektrisch leitfähigen Kleber oder durch Crimpen (nicht gezeigt). Gemäß der in Figur 1 gezeigten Ausführungsform ist die elektrisch leitfähige Beschichtung als teilflächige Beschichtung in Form eines Linienmusters, wie in WO2005/020246 beschrieben, ausgestaltet. Die in der Figur gezeigte Schraffur ist nicht maßstabsgetreu und soll nur das Liniemuster andeuten. Die Beschichtung kann aber auch vollflächig ausgestaltet werden und ist vorzugsweise im Bereich der Elektroden 3 vollflächig ausgestaltet, um dort eine gute Kontaktierung der Elektroden mit der elektrisch leitfähigen Beschichtung zu erreichen.

Figur 2 zeigt einen schematischen Schnitt entlang einer Nahtstelle durch die in Figur 1 gezeigte Ausführungsform eines erfindungsgemäßen elektrisch leitfähigen Flächengebildes (ohne elektrische Zuleitungen 4), aus dem ersichtlich ist, dass durch das Umschlagen des flächigen Trägers im Randbereich die bandförmige Elektrode 3 sowohl mit ihrer Unter- als auch mit ihrer Oberseite in Kontakt mit der elektrisch leitfähigen Beschichtung 2 ist und durch die Naht 5 fixiert wird.

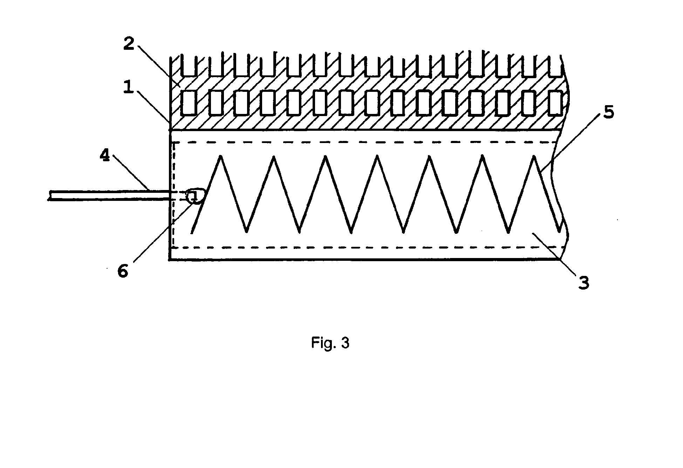

In Figur 3 ist eine Aufsicht auf diesen Randbereich (mit Zuleitungen 4) gezeigt, wobei die durch eine Naht 5 fixierte Elektrode 3, die mit einer Löt- bzw. Klebestelle (6) zur Verbindung der Zuleitung 4 dargestellt ist und wobei das Linienmuster der Beschichtung 2 auf dem Träger 1 dargestellt ist.

Die elektrisch leitfähigen, flexiblen Flächengebilde können ein- oder beidseitig eine Kaschierung aufweisen. In einer bevorzugten Ausführungsform ist wenigstens diejenige Seite des Flächengebildes, welche die elektrisch leitfähige Beschichtung trägt, kaschiert. In einer anderen, ebenfalls bevorzugten Ausführungsform ist das elektrisch leitfähige Flächengebilde beidseitig kaschiert. Die Kaschierung bewirkt eine bessere und gleichmäßigere Wärmeabfuhr bei höheren Leistungseinträgen. Beispiele für geeignete Kaschiermaterialien sind Textilien wie Gewebe, Gewirke, Filze, Non-Wovens und Vliese, sowie weiterhin Kunststoff-Folien, Papier und Schaumfolien, beispielsweise Polyesterurethan-Schaumfolien oder Polyetherurethan-Schaumfolien. Das Kaschieren des erfindungsgemäßen elektrisch leitfähigen, flexiblen Flächengebildes kann in Analogie zur Kaschierung konventioneller flexibler Flächengebilde erfolgen, wie sie beispielsweise dem Fachmann der Textiltechnik geläufig sind (siehe H. K. Rouette, Lexikon für Textilveredelung, Laumannsche Verlagsgesellschaft, Dülmen 1995, S. 950 ff).

Die erfindungsgemäßen elektrisch leitfähigen Flächengebilde können für eine Vielzahl von Anwendungen eingesetzt werden. Da sie hohe Leistungseinträge verkraften, eignen sie sich in besonderer Weise in flexiblen Heizelementen, die auf dem Prinzip einer elektrischen Widerstandsheizung basieren. Dementsprechend betrifft ein weiterer Gegenstand der Erfindung die Verwendung eines elektrisch leitfähigen flexiblen Flächengebildes, wie hier definiert, in flexiblen, elektrischen Heizelementen.

Derartige flexible elektrische Heizelemente weisen in der Regel neben dem erfindungsgemäßen elektrisch leitfähigen, flexiblen Flächengebilde Zuleitungen 4 zum Einspeisen von elektrischem Strom sowie Mittel zur Steuerung des Stromflusses, beispielsweise Ein-Aus-Schalter, Potentiometer sowie sonstige elektrische Regelkreise, auf. Daneben können die elektrisch flexiblen Heizelemente auch einen oder mehrere Mittel zur Temperaturkontrolle, beispielsweise Thermosensoren, enthalten, welche gegebenenfalls mit einem Regelkreis zur Steuerung des elektrischen Stromflusses verbunden sind und somit eine gleichmäßige Thermostatisierung des elektrischen Heizelementes ermöglichen.

Die erfindungsgemäßen elektrischen Heizelemente können in vielfacher Weise verwendet werden, beispielsweise zur Beheizung von Fußboden-, Wand- und Deckenelementen, zur Beheizung benutzerberührter Flächen, wie beispielsweise in Heizdecken oder beheizten Liegeplätzen für Lebewesen, Sitzen und Sesseln, z.B. Autositze, Griffe oder Lenkräder, sowie zur Beheizung beliebiger sonstiger Flächen, an denen eine Beheizung erwünscht ist.

Eine besonders bevorzugte Ausführungsform der Erfindung betrifft die Verwendung erfindungsgemäßer Heizelemente zur Beheizung von Flächen in Fahrgasträumen von Fahrzeugen, speziell von Kraftfahrzeugen. So eignen sie sich beispielsweise zur Beheizung von Wänden in Fahrerkabinen von Lastkraftwagen sowie insbesondere zur Beheizung von benutzerberührten Flächen eines Fahrgastraumes wie Autositze oder Lenkräder.

Eine besonders bevorzugte Ausführungsform der Erfindung betrifft daher einen Autositz, der zumindest im Bereich der Sitzfläche, gegebenenfalls auch im Bereich der Lehne wenigstens ein erfindungsgemäßes Heizelement umfasst. Die Anordnung solcher elektrischen Heizelemente in Autositzen sind aus dem Stand der Technik bekannt, beispielsweise aus G. Schanku, Forscheda 8908480, S. 207 sowie aus DE 4233118.

Die erfindungsgemäßen, elektrisch leitfähigen Flächengebilde können auch in Bekleidung eingesetzt werden. Beispielsweise können die erfindungsgemäßen, elektrisch leitfähigen Flächengebilde dazu dienen, Sensoren und/oder Aktoren, welche in die Kleidung eingearbeitet sind, um dort Informationen über Zustände des Körpers oder seiner Bewegungen aufzunehmen und in elektrische Impulse bzw. Signale umzuwandeln, mit einem oder mehreren Anschlüssen, die zum Anschluss eines Gerätes zur Weiterverarbeitung oder Weiterleitung der durch die Sensoren und/oder Aktoren zur Verfügung gestellten Informationen dienen, elektrisch zu verbinden.

Die folgenden Beispiele dienen der Erläuterung der Erfindung und sind nicht einschränkend zu verstehen.

Die folgenden Versuche wurden unter Verwendung der Zusammensetzung Z1 aus der EP 1284278 durchgeführt.

### Beispiel 1

Die Druckpaste Z1 wurde mittels Siebdruck, 60 mesh, gleichmäßig mit 100 % Flächenbelegung auf ein handelsübliches Kunstleder (Benecke Kaliko) aufgebracht, so dass eine trockene Beschichtung mit einer Auflage von etwa 40 g/m² resultierte. Nach dem Aufbringen der Zusammensetzung trocknete man 2 Minuten bei 180°C. Die Beschichtung wies eine Stärke von etwa 20-40 µm auf.

Aus dem so erhaltenen Kunstleder wurden rechteckige Probenstücke mit den Abmessungen 40 cm x 45 cm ausgeschnitten. An den kurzen Seiten der Probenstücke wurde über die gesamte Länge ein selbstklebendes Kupferband (Breite 1 cm, Länge 40 cm, Stärke 0,38 mm) aufgeklebt. Der Rand wurde nach innen umgeschlagen und der so gebildete Umschlag wurde mit einem Elastan-Faden im Zick-Zack-Stich vernäht. An die Enden der beiden Kupferbänder wurde Litzenkabel aus Kupfer, Querschnitt 1,5 mm², angelötet. Der Abstand zwischen den Elektroden betrug 40 cm.

### Beispiel 2

Als Trägermaterial diente ein Polyester/Polypropylen-Vlies 63 P der Firma Gutsche mit einem Flächengewicht von 79 g/m². Anschließend wurde mittels Siebdruck ein netzförmiges Muster aus zwei zueinander orthogonalen Scharen paralleler Streifen, wie in WO2005/020246 beschrieben, auf das Vlies aufgebracht, wobei eine Trockenauflage von 30 g/m² und eine Pulverauflage von 20 g/m² resultierte. Die abgedeckte Fläche betrug 64 %. Anschließend wurde 2 Minuten bei 180°C getrocknet.

Aus dem so erhaltenen Kunstleder wurden rechteckige Probenstücke mit den Abmessungen 40 cm x 45 cm ausgeschnitten. An den kurzen Seiten der Probenstücke wurde über die gesamte Länge ein selbstklebendes Zinnband (Breite 1 cm, Länge 40 cm, Stärke 0,38 mm) aufgeklebt. Der Rand wurde nach innen umgeschlagen und der so gebildete Umschlag wurde mit einem Elastan-Faden im Zick-Zack-Stich vernäht. An die Enden der beiden Kupferbänder wurde Litzenkabel aus Kupfer, Querschnitt 1,5 mm², angelötet. Der Abstand zwischen den Elektroden betrug 40 cm.

Es wurde die Stromstärke gemessen und der Widerstand der so erhaltenen elektrisch leitfähigen Textilien bestimmt. Die Ergebnisse sind in Tabelle 1 zusammengefasst.

**Tabelle 1:**

| | U [V] | I [A] | R[Ω] | P [W] | P/F [W/m²] ¹⁾ |
|---|---|---|---|---|---|
| Beispiel 1 | | | | | |
| | 6 | 2,3 | 2,6 | 14 | 52 |
| | 12 | 4,5 | 2,7 | 54 | 338 |
| | 18 | 6,5 | 2,8 | 117 | 731 |
| Beispiel 2 | | | | | |
| | 6 | 1,6 | 3,75 | 10 | 45 |
| | 12 | 3,3 | 3,6 | 40 | 250 |
| | 18 | 4,8 | 3,75 | 86 | 538 |

| | | | | | |
|---|---|---|---|---|---|
| 1) Leistung pro Flächeneinheit | | | | | |

### Beispiele 3 bis 10

In den folgenden Beispielen wurde ein nach Beispiel 2 hergestelltes Flächengebilde mit unterschiedlichen Materialien kaschiert. Zum Kaschieren wurden die folgenden Materialien verwendet.
1. Vlies: Vlies Limould 5 FR 27019, Flächengewicht 120 g/m², Hersteller Libeltex, 8760 Meulebeke Belgien.
2. Wasserstrahlvlies: 70/30-Viskose/Polyester, 50 g/m², Hersteller: Fa. Freudenberg, Weinheim, Deutschland.
3. Charmeuse: 45 g/m², Polyamid, Rohweiß, Hersteller: Fa. Boos, Goch, Deutschland.
4. Polyesterurethan-Schaumfolie: Flächengewicht 120 g/m², Hersteller: Fa. Epurex, Walsrode, Deutschland.

### Beispiel 3

Ein gemäß Beispiel 2 hergestelltes Flächengebilde wurde auf der beschichteten Seite mit Vlies und auf der Rückseite mit Schaumfolie und darauf mit Wasserstrahlvlies kaschiert.

### Beispiel 4

Ein nach Beispiel 2 hergestelltes Flächengebilde wurde auf der beschichteten Seite mit Schaumfolie und darauf mit Charmeuse kaschiert. Die Rückseite wurde mit Vlies kaschiert.

### Beispiel 5

Ein nach Beispiel 2 hergestelltes Flächengebilde wurde beidseitig mit Vlies kaschiert.

### Beispiel 6

Ein nach Beispiel 2 hergestelltes Flächengebilde wurde beidseitig mit Schaumfolie und darauf mit Charmeuse kaschiert.

### Beispiel 7

Ein nach Beispiel 2 hergestelltes Flächengebilde wurde auf der beschichteten Seite mit Schaumfolie und darauf mit Charmeuse kaschiert. Die Rückseite wurde mit Vlies kaschiert.

### Beispiel 8

Ein nach Beispiel 2 hergestelltes Flächengebilde wurde auf der beschichteten Seite mit Vlies und auf der Rückseite mit Schaumfolie und darauf mit Charmeuse kaschiert.

### Beispiel 9

Ein nach Beispiel 2 hergestelltes Flächengebilde wurde auf der beschichteten Seite mit Schaumfolie und darauf mit Wasserstrahlvlies kaschiert. Die Rückseite wurde mit Vlies kaschiert.

### Beispiel 10

Ein nach Beispiel 2 hergestelltes Flächengebilde wurde auf der beschichteten Seite mit Vlies und auf der Rückseite mit Schaumfolie und darauf mit Wasserstrahlvlies kaschiert.

Es wurde die Stromstärke gemessen und der Widerstand der kaschierten Textilien bestimmt. Die Ergebnisse sind in Tabelle 2 zusammengefasst.

**Tabelle 2:**

| | I [A] | | | | | | | |
|---|---|---|---|---|---|---|---|---|
| U [V] | Bsp. 3 | Bsp. 4 | Bsp. 5 | Bsp. 6 | Bsp. 7 | Bsp. 8 | Bsp. 9 | Bsp. 10 |
| 6 | 1,7 | 1,3 | 1,6 | 2,0 | 1,3 | 2,1 | 1,0 | 1,5 |
| 12 | 3,4 | 2,7 | 3,2 | 4,0 | 2,6 | 4,1 | 2,1 | 2,9 |
| 18 | 4,8 | 3,8 | 4,6 | 5,3 | 3,8 | 5,8 | 3,0 | 4,2 |

## Patentansprüche

1. Elektrisch leitfähiges Flächengebilde, umfassend eine polymergebundene elektrisch leitfähige Beschichtung (2) auf einem elektrisch nicht leitfähigen flächigen Träger (1) aus flexiblem Material und wenigstens zwei Elektroden (3) zum einspeisen von elektrischem Strom, wobei die Elektroden (3) als Streifen aus einem elektrisch leitfähigen flexiblen Material ausgestaltet sind und wobei jede Elektrode (3) mittels ein oder mehrerer Nähte (5) auf dem flächigen Träger (1) so fixiert ist, dass die jeweilige Kontaktfläche der Elektroden (3) vollflächig mit der elektrisch leitfähigen Beschichtung (2) in Kontakt befindlich ist, wobei die Elektroden (3) und der flächige Träger (1) in einer Weise relativ zueinander angeordnet sind, dass jede Elektrode (3) mit ihrer Oberseite und ihrer Unterseite durch Umschlag des Flächengebildes so mit der elektrisch leitfähigen Beschichtung (2) in Kontakt befindlich ist, dass letztere im Umschlagsbereich innenliegend ist.

2. Flächengebilde nach Anspruch 1, wobei zwei Elektroden (3) an gegenüberliegenden Rändern des flächigen Trägers (1) angeordnet sind, wobei diese gegenüberliegenden Ränder jeweils so umgeschlagen sind, dass die jeweilige Elektrode (3) mit ihrer Oberseite und ihrer Unterseite mit der elektrisch leitfähigen Beschichtung (2) in Kontakt befindlich ist.

3. Flächengebilde nach einem der vorhergehenden Ansprüche, wobei als Elektrodenmaterial ein Folienmaterial mit einer beidseitigen Metalloberfläche oder ein Schmalband aus metallischen oder metallisierten Fäden verwendet wird.

4. Flächengebilde nach einem der vorhergehenden Ansprüche, wobei die Nähte (5) von elastischen Fäden gebildet werden.

5. Flächengebilde nach einem der vorhergehenden Ansprüche, wobei die elektrisch leitfähigen Beschichtung (2) im Wesentlichen aus einem polymeren Bindemittel und einem elektrisch leitfähigen Pulver im Volumenverhältnis Pulver : Bindemittel im Bereich von 1:1 bis 10:1 besteht.

6. Flächengebilde nach Anspruch 5, wobei das elektrisch leitfähige Pulver ausgewählt ist unter Pulvermaterialien, die eine auf einem Kern aus Isolatormaterial angeordnete Edelmetallbeschichtung aufweisen.

7. Flächengebilde nach einem der vorhergehenden Ansprüche, wobei der flexible flächige Träger (1) ausgewählt ist unter Textil, Kunststofffolie, Kunstleder und Leder.

8. Flächengebilde nach einem der vorhergehenden Ansprüche, dessen Seite, welche die elektrisch leitfähige Beschichtung (2) aufweist, kaschiert ist.

9. Flächengebilde nach einem der vorhergehenden Ansprüche, das beidseitig kaschiert ist.

10. Verwendung des elektrisch leitfähigen, flexiblen Flächengebildes nach einem der vorhergehenden Ansprüche in flexiblen elektrischen Heizelementen.

11. Verwendung des elektrisch leitfähigen, flexiblen Flächengebildes nach einem der vorgehenden Ansprüche in Bekleidung.

12. Elektrisches Heizelement, umfassend ein elektrisch leitfähiges, flexibles Flächengebilde nach einem der Ansprüche 1 bis 9, mit den Elektroden (3) verbundene Zuleitungen (4) zum Einspeisen von elektrischem Strom sowie Mitteln zur Steuerung des Stromflusses.

13. Verwendung eines Heizelements nach Anspruch 12 zur Beheizung von Flächen eines Fahrgastraumes in Fahrzeugen.

14. Autositz, umfassend im Bereich der Sitzfläche wenigstens ein Heizelement nach Anspruch 12.

15. Heizdecke, umfassend wenigstens ein Heizelement nach Anspruch 12.

16. Bekleidung, umfassend wenigstens einen Sensor und/oder Aktor zur Aufnahme von Informationen und Umwandlung der Informationen in elektrische Signale sowie wenigstens einen elektrischen Anschluss zum Anschließen von Vorrichtungen zur Verarbeitung der elektrischen Signale, wobei der wenigstens eine Sensor und/oder Aktor mit dem wenigstens einen Anschluss durch ein elektrisch leitfähiges, flexibles Flächengebilde nach einem der Ansprüche 1 bis 9 verbunden ist.

## Claims

1. Electrically conductive sheet material comprising a polymer-bound electrically conductive coating (2) on an electrically nonconductive sheetlike carrier (1) composed of flexible material and at least two electrodes (3) for supplying electric current, the electrodes (3) being configured as strips composed of an electrically conductive flexible material and each electrode (3) being fixed by means of one or more stitches (5) on the sheetlike carrier (1) such that the respective contact area of the electrodes (3) is in uniform contact with the electrically conductive coating (2) wherein the electrodes (3) and the sheetlike carrier (1) are disposed relative to each other such that each electrode (3) is in contact with the electrically conductive coating (2), by the top side and the bottom side of each electrode (3) being in contact with the electrically conductive coating (2), by turning over the sheet material such that the electrically conductive coating (2) comes to lie internally in the turnover region.

2. Sheet material according to Claim 1 wherein two electrodes (3) are disposed at opposite edges of the sheetlike carrier (1) wherein these opposite edges are each turned over such that the respective electrode (3) is in contact with the electrically conductive coating (2) by the top side and the bottom side of the respective electrode (3) being in contact with the electrically conductive coating (2).

3. Sheet material according to any preceding claim wherein a foil material having a both-side metallic surface or a narrow tape formed from metallic or metalized threads is used as electrode material.

4. Sheet material according to any preceding claim wherein the stitches (5) are formed by elastic threads.

5. Sheet material according to any preceding claim wherein the electrically conductive coating (2) consists essentially of a polymeric binder and an electrically conductive powder in a powder:binder volume ratio ranging from 1:1 to 10:1.

6. Sheet material according to Claim 5 wherein the electrically conductive powder is selected from powder materials having a noble metal coating disposed on a core of insulator material.

7. Sheet material according to any preceding claim wherein the flexible sheetlike carrier (1) is selected from textile, plastics foil, leather and artificial leather.

8. Sheet material according to any preceding claim wherein the side which includes the electrically conductive coating (2) is laminated.

9. Sheet material according to any preceding claim wherein both sides are laminated.

10. Use of the electrically conductive flexible sheet material according to any preceding claim in flexible electric heating elements.

11. Use of the electrically conductive flexible sheet material according to any preceding claim in apparel.

12. Electric heating element comprising an electrically conductive flexible sheet material according to any one of Claims 1 to 9 and having lines (4) for feeding electric current connected to the electrodes (3), and also means for controlling current flux.

13. Use of a heating element according to Claim 12 for heating areas of a passenger compartment in vehicles.

14. Automotive seat comprising at least one heating element according to Claim 12 in the region of the seating area.

15. Heating blanket comprising at least one heating element according to Claim 12.

16. Apparel comprising at least one sensor and/or actuator for receiving information items and converting the information items into electrical signals and also at least one electrical connector for connecting devices for processing the electrical signals, wherein the at least one sensor and/or actuator is connected to the at least one connector by an electrically conductive flexible sheet material according to any one of Claims 1 to 9.

## Revendications

1. Produit plat électriquement conducteur, comprenant
un revêtement électriquement conducteur (2) relié par polymère sur un support plat (1) électriquement non conducteur en matériau flexible et
au moins deux électrodes (3) qui permettent d'injecter du courant électrique,
les électrodes (3) étant configurées sous la forme de rubans en matériau flexible électriquement conducteur,
chaque électrode (3) étant fixée sur le support plat (1) au moyen d'une ou plusieurs coutures (5) de telle sorte que la surface de contact de chaque électrode (3) soit en contact par toute sa surface avec le revêtement électriquement conducteur (2),
les électrodes (3) et le support plat (1) étant disposés les unes par rapport à l'autre de telle sorte que chaque électrode (3) soit en contact avec le revêtement électriquement conducteur (2) sur son côté supérieur et son côté inférieur en rabattant le produit plat de telle sorte que ce produit plat soit situé à l'intérieur de la zone du rabattement.

2. Produit plat selon la revendication 1, dans lequel deux électrodes (3) sont disposées sur des bords opposés du support plat (1), ces bords opposés étant chacun rabattus de telle sorte que l'électrode (3) concernée soit en contact avec le revêtement électriquement conducteur (2) par son côté supérieur et son côté inférieur.

3. Produit plat selon l'une des revendications précédentes, dans lequel on utilise comme matériau d'électrode un matériau en feuille doté d'une surface métallique sur ses deux faces ou une bande étroite constituée de fils métalliques ou métallisés.

4. Produit plat selon l'une des revendications précédentes, dans lequel les coutures (5) sont formées de fils élastiques.

5. Produit plat selon l'une des revendications précédentes, dans lequel le revêtement électriquement conducteur (2) est essentiellement constitué d'un liant polymère et d'une poudre électriquement conductrice dans un rapport volumique poudre:liant compris dans la plage de 1:1 à 10:1.

6. Produit plat selon la revendication 5, dans lequel la poudre électriquement conductrice est sélectionnée parmi des matériaux pulvérulents qui présentent un revêtement en métal précieux disposé sur un noyau en matériau isolant.

7. Produit plat selon l'une des revendications précédentes, dans lequel le support plat flexible (1) est sélectionné parmi les textiles, les feuilles de matière synthétique, les cuirs synthétiques et les cuirs.

8. Produit plat selon l'une des revendications précédentes, dont le côté qui présente le revêtement électriquement conducteur (2) est masqué.

9. Produit plat selon l'une des revendications précédentes, masqué sur ses deux faces.

10. Utilisation du produit plat flexible électriquement conducteur selon l'une des revendications précédentes dans des éléments chauffants électriques flexibles.

11. Utilisation du produit plat flexible électriquement conducteur selon l'une des revendications précédentes dans des habillages.

12. Elément chauffant électrique comprenant un produit plat flexible électriquement conducteur selon l'une des revendications 1 à 9, des conducteurs d'amenée (4) reliés aux électrodes (3) et qui apportent le courant électrique ainsi que des moyens de commande de l'intensité du courant.

13. Utilisation d'un élément chauffant selon la revendication 12 pour le chauffage de surfaces de l'habitacle de véhicules automobiles.

14. Siège de voiture comprenant au niveau de sa surface d'assise au moins un élément chauffant selon la revendication 12.

15. Toit chauffant comprenant au moins un élément chauffant selon la revendication 12.

16. Habillage, comprenant au moins un détecteur et/ou un actionneur qui reçoit des informations et qui convertit les informations en signaux électriques, ainsi qu'au moins un raccordement électrique qui permet de raccorder des dispositifs de traitement des signaux électriques, le ou les détecteurs et/ou actionneurs étant reliés à la ou aux bornes de raccordement par un produit plat flexible électriquement conducteur selon l'une des revendications 1 à 9.
